# EUROPEAN PATENT SPECIFICATION

(11) **EP 0 709 782 B1**
(45) Date of publication and mention of the grant of the patent: **03.03.1999**
(21) Application number: 95110826.5
(22) Date of filing: 11.07.1995
(51) Int. Cl.: G06F 11/16, G06F 11/10, G06F 11/20

(54) **Error detection system and method for mirrored memory between dual disk storage controllers**
Fehlererkennungs-System und -Verfahren für gespiegelten Speicher zwischen doppelten Plattenspeichersteuerungen
Système et méthode de détection d'erreurs pour mémoire reflétée entre contrôleurs doublés de disque mémoire

(30) Priority: 25.10.1994 US 329556
(43) Date of publication of application: 01.05.1996
(73) Proprietor: Hewlett-Packard Company, Palo Alto, California 94304 (US)
(72) Inventor: Oldfield, Barry J., Boise, Idaho 83713 (US); Petersen, Mark D., Boise, Idaho 83709 (US)
(74) Representative: Schoppe, Fritz, Dipl.-Ing.

(56) References cited:
- EP-A- 0 582 370
- GB-A- 2 220 091
- US-A- 5 005 174
- IBM JOURNAL OF RESEARCH AND DEVELOPMENT, vol. 35, no. 3, 1 May 1991, pages 382-388, XP000266484 TURGEON P R ET AL: "TWO APPROACHES TO ARRAY FAULT TOLERANCE IN THE IBM ENTERPRISE SYSTEM/9000 TYPE 9121 PROCESSOR"
- PROCEEDINGS OF THE ANNUAL INTERNATIONAL SYMPOSIUM ON COMPUTER ARCHITECTURE, SAN DIEGO, MAY 16 - 19, 1993, no. SYMP. 20, 16 May 1993, INSTITUTE OF ELECTRICAL AND ELECTRONICS ENGINEERS, pages 76-86, XP000398988 MENON J ET AL: "THE ARCHITECTURE OF A FAULT-TOLERANT CACHED RAID CONTROLLER"

## Description

### FIELD OF THE INVENTION

This invention relates in general to computer disk storage controllers and, more particularly, to a system for detecting mirrored memory data errors in a dual controller disk storage system.

### BACKGROUND OF THE INVENTION

In high reliability computer disk storage systems, there is a desire to have redundancy in all the physical parts which make up a subsystem to reduce the potential for loss of data and down time upon failure of a part. The use of dual disk storage controllers, each having its own memory, provides several major benefits to a disk storage system. For example, (1) a redundancy of storage information is retained to allow for recovery in the case of failure or loss of one controller or its memory; (2) repair of a disabled controller is feasible due to the failover capabilities of the secondary controller; and (3) greater system up time is achieved through the secondary controller being available.

With the desire for more performance out of these redundant subsystems, caching and the use of memory as temporary storage has become commonplace. The means by which these duplicate physical memories are kept in synchronization can be difficult. Some disk systems use a latent (delayed or massive update) process to create this duplication, but that approach tends to add expense and is very complex to manage. Another approach (the one used in this invention) is to form a real-time mirrored memory process to create and retain accurate this duplication of data. The use of real-time, synchronized, redundant memory (mirrored memory) in dual controllers can improve speed and accuracy in the case of a failover from one controller to the other.

However, this use of redundant memory makes the problem of providing multiple disk storage controller solutions substantially more difficult. Exemplary of the significant problems to overcome include how to effectively and reliably (1) detect data errors in the mirrored memory without loss of processing speed, and (2) identify the source of the data errors, i.e., which side of the mirror retains the corrupt data.

Given the foregoing problems associated with error detection in mirrored memory in a multiple controller disk storage system, and other problems not addressed herein, it is not generally taught in the prior art to use mirrored memory between controllers in a multiple controller system.

US Patent 5,005,174 discloses a dual zone, fault tolerant computer system including a first processing system and a second processing system, substantially identical to the first processing system. Fault detection devices are coupled to first and second data output terminals of the first and second processing systems for comparing the data output from the first processing system to the data output from the second processing system. The fault detection devices identify the presence of an error when the data output from the first processing system at the first output terminal is different from the data output from the second processing system at the second output terminal.

This prior art reference is , however, silent about means for granting to a selected one of the disk controllers sole access to the memory of the selected disk controller and simultaneously memory of at least one of the other disk controllers.

Accordingly, objects of the present invention are to provide an effective and reliable mirrored memory data error detection system for real-time, synchronous, mirrored memory controllers in a dual controller disk storage system.

### SUMMARY OF THE INVENTION

According to principles of the present invention in its preferred embodiment, an error detection system and method as defined in independent claims 1 and 5 respectively, is disclosed for reliably detecting memory data errors in a disk storage system having dual controllers and mirrored memory therebetween. The system and method includes means for fetching first data from the memory of one of the controllers and, substantially simultaneously, fetching second data from the mirrored memory address location of the other controller. The system and method further includes means for detecting an error in the first and second data separately and, substantially simultaneously, detecting an error in the first and second data relative to each other.

According to further principles of the present invention, the means for separately detecting an error in the first and second data includes means for employing Error Correcting Code (ECC) correction on the first and second data respectively. Moreover, the means for detecting an error in the first and second data relative to each other includes means for comparing the first data with the second data for determining whether there is a match.

According to further principles of the present invention, arbitration means manages the granting to one of the controllers access to the memory of both of the controllers for simultaneously reading from both sides of the mirror and error checking the data.

Other objects, advantages, and capabilities of the present invention will become more apparent as the description proceeds.

### DESCRIPTION OF THE DRAWINGS

Figure 1 is a block diagram representing an overview of the present invention system for detecting data errors in a dual disk storage controller system having mirrored memory therebetween.

Figure 2 is a more detailed schematic block diagram of the present invention.

Figure 3 is the schematic block diagram of Figure 2 wherein unidirectional paths of communication and data transfer are depicted for detecting data errors during a read from mirrored memory according to principles of the present invention.

### DETAILED DESCRIPTION OF THE INVENTION

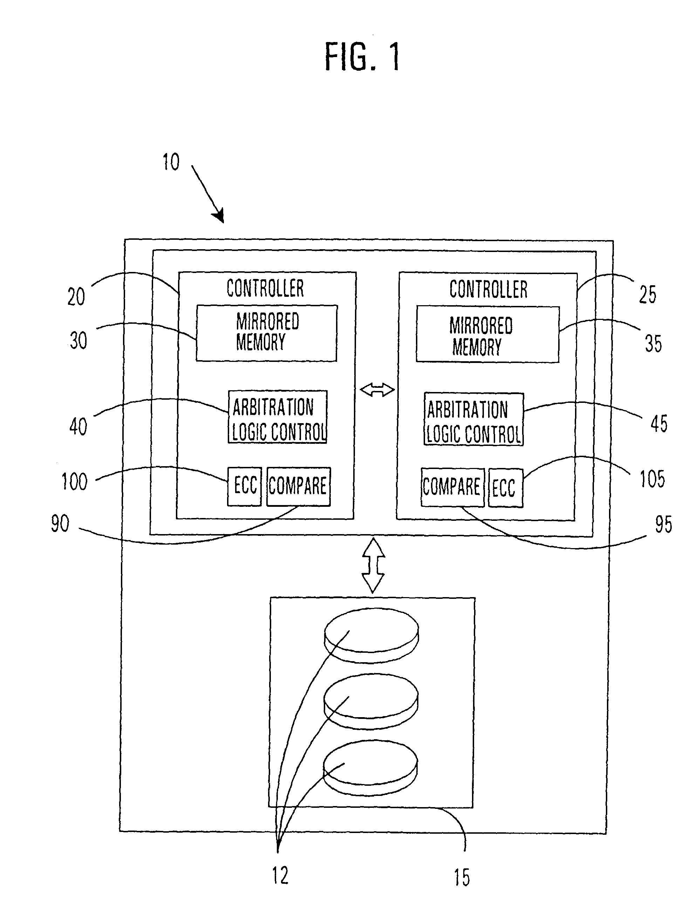

Figure 1 is a block diagram representing an overview of the present invention system for detecting data errors in a dual disk storage controller system 10 having mirrored memory therebetween. Disk storage control system 10 includes disk storage subsystem 15 having disk storage devices 12 therein and dual disk storage controllers 20 and 25. Controllers 20 and 25 each have memory 30 and 35, respectively.

Although most any type of Random Access Memory (RAM) is suitable for use as memory 30 and 35, in the preferred embodiment a non-volatile RAM (or volatile RAM made non-volatile by use of a power supply backup) is used to allow for retention of data in the event of a power failure. Moreover, although only dual controllers 20 and 25 are shown in the diagram and discussed generally herein, it will be obvious that the principles expressed and implied herein are likewise applicable in a multiple controller environment, i.e., more than two controllers.

Each memory 30 and 35 is a mirrored memory. As is well known in the art, mirrored memory simply means that data in one memory is duplicated or "mirrored" in another memory. As used in the present invention, mirrored memory means that data in the memory of one controller is duplicated or "mirrored" in the memory of the other controller. The existence of dual controllers, and mirrored memory in each, provides a fault tolerant environment for disk storage system 10. Namely, in the event of a failure of one of the controllers, or one of the controller memories, the existence of the other controller and its mirrored memory provides a seamless fail-over option for continued processing. In this context, communication occurs between controllers 20 and 25 to provide a cost effective real-time link and to allow each controller to monitor the state of the duplicate controller and to coordinate activities.

In the preferred embodiment, the mirrored memory is a real-time mirrored memory, i.e., a single microprocessor or direct memory access updates data into or retrieves data from both memories 30 and 35 at substantially the same time. Arbitration logic 40 and 45 controls when each controller is granted access to update or retrieve data from the memory. Arbitration logic 40 and 45 communicate with each other so that each knows which controller has current access to the memories.

In the preferred embodiment, arbitration logic 40 and 45 only allow one controller to access the memories at a single time. For example, when arbitration logic 40 grants controller 20 access to memory 30, it likewise grants controller 20 access to memory 35 of controller 25 by enabling/disabling appropriate signal lines. This allows for controller 20 to simultaneously access both memories. Accordingly, when arbitration logic 40 grants controller 20 access to memories 30 and 35, arbitration logic 45 disallows controller 25 from accessing either memory.

Given that one of the key purposes of a dual controller configuration is to allow for the capability of immediate failover from one controller to the other in the event of a failure, it is imperative that the memory contents of each controller be identical before a failover occurs so that operation will continue uninterrupted. Accordingly, the present invention focuses on data error detection during real-time, substantially simultaneous retrieval of data from both memories 30 and 35. Pursuant to arbitration logic 40 and 45, when a controller accesses both memories a first data is fetched from one of the memories 30 and 35, and a second data is fetched simultaneously from the other of the memories 30 and 35. First and second data are retrieved from mirrored address locations in memories 30 and 35 respectively. First and second data may comprise single or multiple bits (or bytes) of data.

Immediately upon being fetched, the first and second data are separately and independently checked for errors by implementation of Error Correcting Codes (ECC) 100 and 105. Substantially simultaneously, the first and second data are also compared to each other, 90 and 95, to determine if an error has occurred therebetween. In the event of no error being detected, access proceeds normally and the compare process has no impact on access time if data values match. However, if an error is detected by the ECC check or the compare check, then signal lines (bits) are set to notify a control processor of the error. Given each of these three separate error checks, the source of the error can generally be determined, (namely, it can be determined from which side of the mirror is the data corrupted). Accordingly, appropriate action may then be taken to respond to the error, and as such, reliability of the memory system is increased.

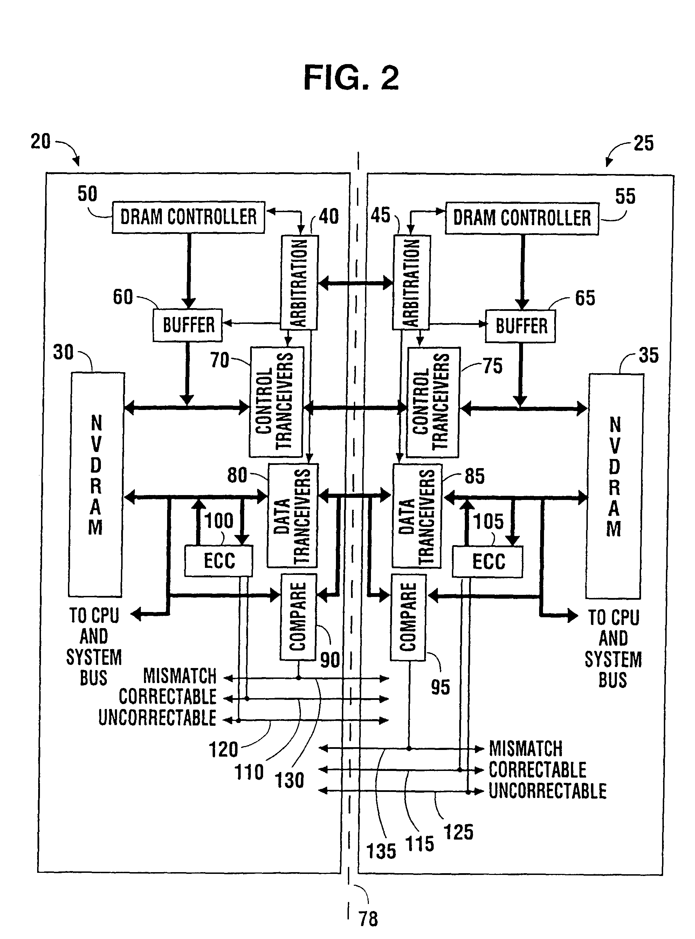

Referring now to Figure 2, a more detailed schematic block diagram of the present invention system is shown. Similar components between Figures 1 and 2 retain similar reference numbers. Accordingly, each controller 20 and 25 is referenced generally, each mirrored memory 30 and 35 is referenced as Non-Volatile Dynamic Random Access Memory (NVDRAM) as used in the preferred embodiment, arbitration logic 40 and 45, ECC circuitry 100 and 105, and compare circuitry 90 and 95 are all likewise referenced as in Figure 1. For simplicity purposes, NVDRAM controllers 50 and 55 will be referred to herein as DRAM controllers. All directional arrows indicate paths of communication and/or transfer of data.

Each controller 20 and 25 has its own internal clock (not shown) for governing its respective circuitry as a whole. As previously mentioned in reference to Figure 1, arbitration logic 40 and 45 control which controller is granted access to the memories 30 and 35 and which controller is disabled from accessing the same. Arbitration logic 40 and 45 communicate, respectively, with each other, with DRAM controllers 50 and 55, buffers 60 and 65, control transceivers 70 and 75, and data transceivers 80 and 85.

As common in the art, DRAM controllers 50 and 55 manage and generate timing and control logic signals, such as Row Address Select (RAS), Column Address Select (CAS), Write Enable (WE), Output Enable (OE), etc., for accessing appropriate addresses in DRAM 30 and 35, respectively. Buffers 60 and 65 are DRAM controller buffers for enabling/disabling each DRAM controller 50 and 55 with respect to accessing DRAM 30 and 35, respectively.

Control transceivers 70 and 75 are bi-directional transceiver buffers for the local controller (i.e., the controller on which the transceiver resides) to (1) drive address signals to a backplane 78 of the computer system to access the other (remote) controller's memory, or (2) receive address signals from the remote controller through the backplane to access the local controller's memory. Likewise, data transceivers 80 and 85 are bi-directional transceiver buffers for a local controller to (1) drive data signals to the backplane 78 to send to the remote controller, or (2) receive data signals from the remote controller through the backplane.

ECC logic 100 and 105 perform all ECC checking and correction on data read from respective DRAM blocks 30 and 35. The ECC logic initially generates Check bits based on the data (bits) written to the DRAM. These Check bits are stored with the data bits in DRAM when the write is performed. During DRAM read accesses, the Check bits are read back with the data (bits) and compared with recalculated Check bits (i.e., Check bits recalculated from the data read back as compared to the Check bits stored when the data was initially written to DRAM). By comparing the stored Check bits with the recalculated check bits the ECC logic can detect and correct all single bit errors and can detect all two bit errors. Errors of more than two bits are not guaranteed to be detected. If an error is detected, appropriate signal lines (bits) 110, 115, 120, and 125 are set to notify the processor or logic which manages such errors (in the instant invention, DRAM controllers 50 and 55).

To further increase data reliability in conjunction with ECC logic 100 and 105, compare circuitry 90 and 95 perform a full compare of first and second data read from DRAM 30 and 35, respectively. Since multiple bit errors will not be detected by the ECC logic, compare circuitry 90 and 95 are used to determine if the data stored on each controller is identical. In essence, the first and second data are compared to determine if there is a match (i.e., from being mirrored) or if there is a mismatch which indicates an error in one of the data. By comparing the data relative to each other, all errors of any number of bits are detected.

One of the novel aspects of the present invention is that the ECC error detection occurs separately on each controller for the data read from that controller, and, substantially simultaneously, the same data read from both sides of the mirrored memory are compared relative to each other. No extra clock cycles are required for the compare, and the overall reliability of the system is increased. Moreover, given the error signal bit settings, it can generally be determined from which side of the mirror the error occurred.

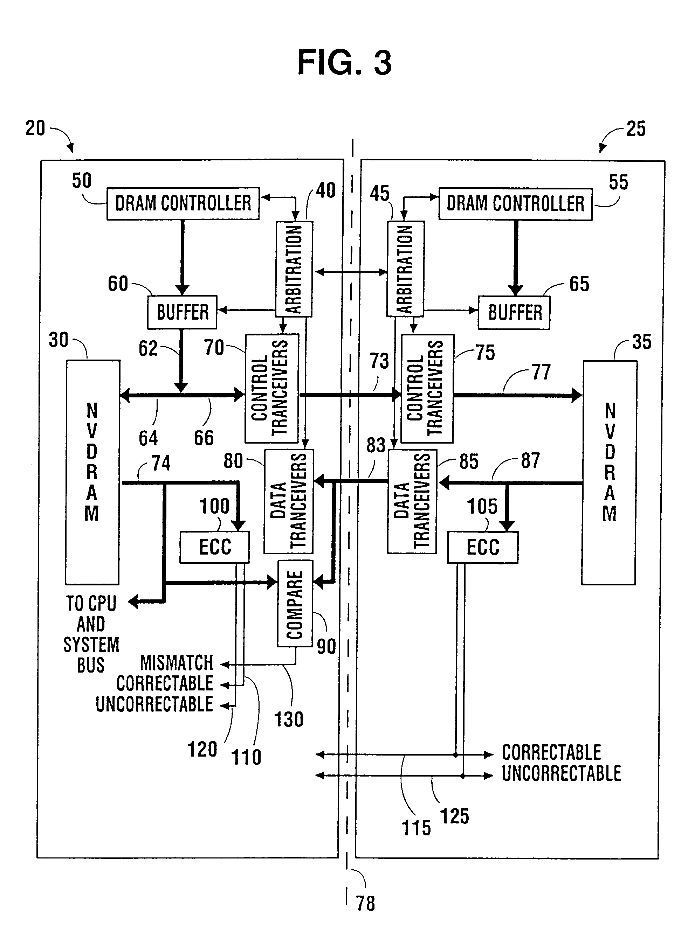

Operation of Figure 2 is best described by a descriptive example as shown in Figure 3. Figure 3 is the same as Figure 2 except that the bi-directional arrows of Figure 2 are substituted in Figure 3 with uni-directional arrows depicting the actual directional paths of communication and data transfer for detecting data errors during a read from mirrored memory by controller 20.

In the event that controller 20 initiates a read, DRAM controller 50 asserts a Request to its own arbitration logic 40. Arbitration logic 40 then enters a Request state and waits for arbitration logic 45 of controller 25 to enter into a Slave state. A Request state is when the local arbitration logic 40 (in this example) waits for the remote arbitration logic 45 to grant controller 20 access to remote DRAM 35. A Slave state is when arbitration logic 45 disables DRAM controller buffer 65 (in this example) to grant controller 20 access to DRAM 35.

More specifically, when DRAM controller 55 of controller 25 completes its cycle for using the memory (either for reading or writing), it removes its own Request to arbitration logic 45 and enters into a Slave state. Upon entering the Slave state, arbitration logic 45 disables DRAM controller buffer 65 as shown by the fact that no directional arrow proceeds out from (points away from) buffer 65. Arbitration logic 45 also sets control transceivers 75 to drive address signals from backplane 78 to DRAM 35 as shown by directional arrows 73 and 77, and sets data transceivers 85 to drive data from DRAM 35 to backplane 78 as shown by directional arrows 87 and 83.

Arbitration logic 40 acknowledges this by entering into a Master state wherein controller 20 is allowed access to both memories 30 and 35. Arbitration logic 40 enables its local DRAM controller buffer 60 as shown by directional arrow 62; sets control transceivers 70 to drive from controller 20 to backplane 78 as shown by directional arrow 73; and disables data transceivers 80 as shown by the fact that no directional arrow proceeds out from (points away from) data transceivers 80.

Next, DRAM controller 50 performs a DRAM read cycle by driving the row address and OE signals to access its own DRAM 30 as shown by directional arrow 64 and by driving the same through control transceivers 70 and 75 to access DRAM 35 of controller 25 as shown by directional arrows 66, 73 and 77. Controller 50 enables its own ECC logic 100, and controller 55 enables its own ECC logic 105, for appropriate checking of data read from the respective DRAM arrays 30 and 35. RAS is then asserted, the column address is driven, and CAS is likewise asserted to read appropriate first data from DRAM 30 (as shown by directional arrow 74), and, substantially simultaneously, second data from DRAM 35 (as shown by directional arrows 87 and 83). Obviously, this reading of data from DRAM 30 and 35 is a fetching of data from mirrored address locations, i.e., address locations retaining the same "mirrored" data.

The first data is read from DRAM 30 and processed through ECC logic 100 for error checking and correction. Likewise, the second data is read from DRAM 35 and processed through ECC logic 105 for error checking and correction. In each instance, ECC checking occurs by reading the Check bits associated with the data being read. Namely, Check bits were originally calculated from the data when the data was initially written to DRAM, and those Check bits were stored in DRAM along with the data itself. Consequently, during a read cycle of the data, the stored Check bits are read back and compared with newly recalculated Check bits (i.e., check bits created from currently reading the data). If a discrepancy exists, a correction is made (if possible) and an appropriate error signal (status bit) is latched for subsequent processing of the error. For example, if a correctable error is detected with the first data in ECC logic 100, the error is corrected and correctable signal line 110 (status bit) is set to notify appropriate control logic. On the other hand, if an uncorrectable error is detected with the second data in ECC logic 105, uncorrectable signal line 125 (status bit) is set.

Substantially simultaneously with the ECC checking, the second data (along with its Check bits) from DRAM 35 is passed through data transceiver 85 and backplane 78 over to compare logic 90 of controller 20. Data transceiver 80 is disabled to avoid a clashing of the first data (along with its Check bits) read from DRAM 30 with the second data read from DRAM 35. The first data from DRAM 30 and the second data from DRAM 35 are both allowed to pass to compare logic 90 of controller 20. Compare logic 90 compares the first and second data to determine if a there is a match. If a match exists, processing continues normally. In contrast, if there is not a match, mismatch signal line 130 (status bit) is set to notify appropriate control logic of the error.

In summary, ECC logic 100 and 105 separately and independently check for data errors in respective local data that passes through the logic on a read cycle. Substantially simultaneously, the data is compared in compare logic 90 (in this Figure 3 example) to catch multiple bit errors not detectable by ECC logic 100 and 105. While processing, each ECC and compare check sets appropriate status bits upon detection of an error. At the end of the read cycle, DRAM controller 50 checks the status bits from the ECC and compare logic to see if either has latched an error and to process the error (if any) appropriately.

What has been described above are the preferred embodiments for a system and method for detecting data errors in dual disk storage controllers having mirrored memory therebetween. It is clear that the present invention offers a powerful tool for increasing reliability in a mirrored memory dual controller system. Moreover, it will be obvious to one of ordinary skill in the art that the present invention is easily implemented utilizing any of a variety of hardware platforms and software tools existing in the art. While the present invention has been described by reference to specific embodiments, it will be obvious that other alternative embodiments and methods of implementation or modification may be employed without departing from the scope of the invention as defined in the appended claims.

## Claims

1. A data error detection system for a computer disk storage control system (10) having a plurality of disk controllers (20,25), comprising:
(a) memory (30,35) in each of the plurality of disk controllers (20,25) wherein the memory (30,35) of each disk controller is mirrored memory with respect to each other disk controller memory;
(b) means (40,45) for granting to a selected one of the disk controllers (20,25) sole access to the memory of the selected disk controller and simultaneously the memory of at least one of the other disk controllers (20,25) ;
(c) means (80,85) for fetching first data from the memory of the selected one of the disk controllers (20,25) and, simultaneously, fetching second data from the memory of the at least one of the other disk controllers (20,25);
(d) means (100,105) for detecting an error in the first and second data separately; and,
(e) means (90,95) for detecting an error in the first and second data relative to each other simultaneously with detecting an error in the first and second data separately.

2. The system according to claim 1 wherein the means for separately detecting an error in the first and second data includes means for employing Error Correcting Code (ECC) correction (100,105) on the first and second data respectively.

3. The system according to claim 1 or 2, wherein the means for detecting an error in the first and second data relative to each other includes means for comparing (90,95) the first data with the second data for determining whether there is a match.

4. The system according to one of claims 1 to 3 further including means for signaling an error detection:
(a) based on compare results (130,135) from comparing the first data with the second data; and,
(b) based on ECC results (110,115,120,125) from each of the first and second data separately.

5. A method of detecting errors in a computer disk storage control system (10) having a plurality of disk controllers (20,25), each disk controller having a mirrored memory (30,35) with respect to each other, the method comprising the steps of:
(a) granting to a selected one of the disk controllers (20,25) sole access to the memory of the selected disk controller and simultaneously the memory of at least one of the other of the disk controllers
(b) fetching first data from the memory of the selected one of the disk controllers (20,25) and, simultaneously, fetching second data from the memory of the one of the other disk controllers;
(c) detecting an error in the first and second data separately (100,105); and,
(d) detecting an error in the first and second data relative to each other (90,95) simultaneously with detecting an error in the first and second data separately.

6. The method according to claim 5 wherein the step of separately detecting an error in the first and second data includes employing Error Correcting Code (ECC) correction (100,105) on the first and second data, respectively.

7. The method according to claim 5 or 6 wherein the step of detecting an error in the first and second data relative to each other includes comparing (90,95) the first data with the second data for determining whether there is a match.

8. The method according to one of claims 5 to 7 further including the step of signaling an error detection by signaling:
(a) a compare error (130,135) from comparing the first data with the second data; and,
(b) an ECC error (110,115,120,125) from each of the first and second data separately.

## Patentansprüche

1. Ein Datenfehlererfassungssystem für ein Computerplattenspeicherungssteuerungssystem (10) mit einer Mehrzahl von Plattensteuerungseinrichtungen (20, 25), mit folgenden Merkmalen:
(a) einem Speicher (30, 35) in jeder der Mehrzahl von Plattensteuerungseinrichtungen (20, 25), wobei der Speicher (30, 35) jeder Plattensteuerungseinrichtung hinsichtlich jedes anderen Plattensteuerungseinrichtungsspeichers ein gespiegelter Speicher ist;
(b) einer Einrichtung (40, 45) zum Gewähren eines alleinigen Zugriffs auf den Speicher der ausgewählten Plattensteuerungseinrichtung und gleichzeitig auf den Speicher von zumindest einer der anderen Plattensteuerungseinrichtungen (20, 25) einer ausgewählten der Plattensteuerungseinrichtungen (20, 25);
(c) einer Einrichtung (80, 85) zum Abrufen von ersten Daten aus dem Speicher der ausgewählten der Plattensteuerungseinrichtungen (20, 25) und zum gleichzeitigen Abrufen von zweiten Daten aus dem Speicher der zumindest einen der anderen Plattensteuerungseinrichtungen (20, 25);
(d) einer Einrichtung (100, 105) zum getrennten Erfassen eines Fehlers in den ersten und zweiten Daten; und
(e) einer Einrichtung (90, 95) zum Erfassen eines Fehlers in den ersten und zweiten Daten bezüglich einander gleichzeitig mit dem getrennten Erfassen eines Fehlers in den ersten und zweiten Daten.

2. Das System gemäß Anspruch 1, bei dem die Einrichtung zum getrennten Erfassen eines Fehlers in den ersten und zweiten Daten eine Einrichtung zum Verwenden einer ECC-Korrektur (ECC = Error Correcting Code = Fehlerkorrekturcode) (100, 105) bei den ersten bzw. zweiten Daten umfaßt.

3. Das System gemäß Anspruch 1 oder 2, bei dem die Einrichtung zum Erfassen eines Fehlers in den ersten und zweiten Daten bezüglich einander eine Einrichtung zum Vergleichen (90, 95) der ersten Daten mit den zweiten Daten umfaßt, um zu bestimmen, ob eine Übereinstimmung vorliegt.

4. Das System gemäß einem der Ansprüche 1 bis 3, das ferner eine Einrichtung zum Signalisieren einer Fehlererfassung:
(a) basierend auf Vergleichsergebnissen (130, 135) aus einem Vergleich der ersten Daten mit den zweiten Daten; und
(b) basierend auf ECC-Ergebnissen (110, 115, 120, 125) jeweils getrennt aus den ersten und zweiten Daten aufweist.

5. Ein Verfahren zum Erfassen von Fehlern in einem Computerplattenspeicherungssteuerungssystem (10) mit einer Mehrzahl von Plattensteuerungseinrichtungen (20, 25), wobei jede Plattensteuerungseinrichtung einen gespiegelten Speicher bezüglich jeder anderen (30, 35) aufweist, wobei das Verfahren folgende Schritte aufweist:
(a) Gewähren eines alleinigen Zugriffs auf den Speicher der ausgewählten Plattensteuerungseinrichtung und gleichzeitig auf den Speicher von zumindest einer der anderen Plattensteuerungseinrichtungen einer ausgewählten der Plattensteuerungseinrichtungen (20, 25);
(b) Abrufen von ersten Daten aus dem Speicher der ausgewählten der Plattensteuerungseinrichtungen (20, 25) und gleichzeitiges Abrufen von zweiten Daten aus dem Speicher der einen der anderen Plattensteuerungseinrichtungen;
(c) getrenntes Erfassen (100, 105) eines Fehlers in den ersten und zweiten Daten; und
(d) Erfassen (90, 95) eines Fehlers in den ersten und zweiten Daten bezüglich einander gleichzeitig mit dem getrennten Erfassen eines Fehlers in den ersten und zweiten Daten.

6. Das Verfahren gemäß Anspruch 5, bei dem der Schritt des getrennten Erfassens eines Fehlers in den ersten und zweiten Daten ein Verwenden einer ECC-Korrektur (ECC = Error Correcting Code = Fehlerkorrekturcode) (100, 105) bei den ersten bzw. zweiten Daten umfaßt.

7. Das Verfahren gemäß Anspruch 5 oder 6, bei dem der Schritt des Erfassens eines Fehlers in den ersten und zweiten Daten bezüglich einander ein Vergleichen (90, 95) der ersten Daten mit den zweiten Daten umfaßt, um zu bestimmen, ob eine Übereinstimmung vorliegt.

8. Das Verfahren gemäß einem der Ansprüche 5 bis 7, das ferner den Schritt des Signalisierens einer Fehlererfassung aufweist, indem:
(a) ein Vergleichsfehler (130, 135) aus einem Vergleich der ersten Daten mit den zweiten Daten signalisiert wird; und
(b) ein ECC-Fehler (110, 115, 120, 125) getrennt jeweils aus den ersten und zweiten Daten signalisiert wird.

## Revendications

1. Système de détection d'erreurs de données pour un système de commande de stockage sur disque d'ordinateur (10) comportant une pluralité de contrôleurs de disques (20, 25), comprenant :
(a) une mémoire (30, 35) dans chaque contrôleur de ladite pluralité de contrôleurs de disques (20, 25), où la mémoire (30, 35) de chaque contrôleur de disque est une mémoire en miroir par rapport à chaque autre mémoire de contrôleur de disque ;
(b) des moyens (40, 45) pour allouer à un contrôleur sélectionné parmi les contrôleurs de disques (20, 25) un accès réservé à la mémoire du contrôleur de disque sélectionné et en même temps, à la mémoire d'un au moins des autres contrôleurs de disques (20, 25);
(c) des moyens (80, 85) pour aller chercher des premières données dans la mémoire du contrôleur sélectionné des contrôleurs de disques (20, 25) et en même temps, aller chercher des deuxièmes données dans la mémoire du un au moins des autres contrôleurs de disques (20, 25);
(d) des moyens (100, 105) pour détecter une erreur dans les premières et deuxièmes données, séparément ; et
(e) des moyens (90, 95) pour détecter une erreur dans les premières et deuxièmes données, les unes par rapport aux autres, en même temps qu'en détectant une erreur dans les premières et deuxièmes données, séparément.

2. Système selon la revendication 1, dans lequel les moyens pour détecter séparément une erreur dans les premières et deuxièmes données comportent des moyens pour utiliser une correction par un code correcteur d'erreur (ECC) (100, 105), respectivement sur les premières et deuxièmes données.

3. Système selon la revendication 1 ou 2, dans lequel les moyens pour détecter une erreur dans les premières et deuxièmes données, les unes par rapport aux autres, comportent des moyens pour comparer (90, 95) les premières données aux deuxièmes données pour déterminer s'il y a une correspondance.

4. Système selon l'une des revendications 1 à 3, comportant en outre des moyens pour signaler une détection d'erreur.

5. Procédé de détection d'erreurs dans un système de commande de stockage sur disque d'ordinateur (10) comportant une pluralité de contrôleurs de disques (20, 25), chaque contrôleur de disque comportant une mémoire en miroir (30, 35) par rapport à un autre, le procédé comprenant les étapes consistant à :
(a) allouer à un contrôleur sélectionné parmi les contrôleurs de disques (20, 25) un accès réservé à la mémoire du contrôleur de disque sélectionné et en même temps, à la mémoire d'un au moins des autres contrôleurs de disques ;
(b) aller chercher des premières données dans la mémoire du contrôleur sélectionné des contrôleurs de disques (20, 25) et en même temps, aller chercher des deuxièmes données dans la mémoire du un au moins des autres contrôleurs de disques ;
(c) détecter une erreur dans les premières et deuxièmes données, séparément (100, 105) ; et
(d) détecter une erreur dans les premières et deuxièmes données, les unes par rapport aux autres (90, 95), en même temps qu'en détectant une erreur dans les premières et deuxièmes données, séparément.

6. Procédé selon la revendication 5, dans lequel l'étape consistant à détecter séparément une erreur dans les premières et deuxièmes données comporte l'utilisation d'une correction par un code correcteur d'erreur (ECC) (100, 105), respectivement sur les premières et deuxièmes données.

7. Procédé selon la revendication 5 ou 6, dans lequel l'étape consistant à détecter une erreur dans les premières et deuxièmes données, les unes par rapport aux autres, comporte la comparaison (90, 95) des premières données aux deuxièmes données pour déterminer s'il y a une correspondance.

8. Procédé selon l'une des revendications 5 à 7, comportant en outre l'étape consistant à signaler une détection d'erreur en signalant :
(a) une erreur de comparaison (130, 135) d'après la comparaison des premières données aux deuxièmes données ; et
(b) une erreur ECC (110, 115, 120, 125) de chacune des premières et deuxièmes données, séparément.
